# EUROPÄISCHE PATENTSCHRIFT

(11) **EP 1 046 993 B1**
(45) Veröffentlichungstag und Bekanntmachung des Hinweises auf die Patenterteilung: **19.02.2003**
(21) Anmeldenummer: 00107305.5
(22) Anmeldetag: 04.04.2000
(51) Int. Cl.: G06F 11/20, G11C 29/00

(54) **Halbleiterspeicheranordnung mit BIST**
Semiconductor memory with Built-In Self Test
Circuit de mémoire à auto-test incorporé

(30) Priorität: 19.04.1999 DE 19917588
(43) Veröffentlichungstag der Anmeldung: 25.10.2000
(73) Patentinhaber: Infineon Technologies AG, 81669 München (DE)
(72) Erfinder: Pöchmüller, Peter, Dr., 81739 München (DE)
(74) Vertreter: Müller - Hoffmann & Partner

(56) Entgegenhaltungen:
- US-A- 6 032 264
- KOWARIK O: "SELF-REPAIRING SEMICONDUCTOR MEMORY CHIP WITH IMPROVED AVAILABILITY / RELIABILITY" PROCEEDINGS OF THE CUSTOM INTEGRATED CIRCUITS CONFERENCE,US,NEW YORK, IEEE, Bd. CONF. 9, 1987, Seiten 598-601, XP000757371
- RITTER J C ET AL: "BUILT-IN TEST PROCESSOR FOR SELF-TESTING REPAIRABLE RANDOM ACCESS MEMORIES" PROCEEDINGS OF THE INTERNATIONAL TEST CONFERENCE,US,WASHINGTON, IEEE COMP. SOC. PRESS, Bd. CONF. 18, 1988, Seiten 1078-1084, XP000745843
- BHAVSAR D K ET AL: "TESTABILITY STRATEGY OF THE ALPHA AXP 21164 MICROPROCESSOR" PROCEEDINGS OF THE INTERNATIONAL TEST CONFERENCE,US,NEW YORK, IEEE,1994, Seiten 50-59, XP000519963 ISBN: 0-7803-2103-0

## Beschreibung

Die vorliegende Erfindung betrifft eine Halbleiterspeicheranordnung mit einem über Wortleitungen und Bitleitungen angesteuerten Speicherzellenfeld aus einer Vielzahl von Speicherzellen und mit redundanten Speicherzellen, die bei einem Ausfall von Speicherzellen des Speicherzellenfeldes diese als Spare-Speicherzellen ersetzen, wobei die Speicherzellen des Speicherzellenfeldes und die Spare-Speicherzellen auf einem Halbleiterchip vorgesehen sind.

Halbleiterspeicheranordnungen, wie beispielsweise DRAMs (dynamische Schreib/Lesespeicher) können praktisch nicht ohne Ausfall von Speicherzellen in einem Speicherzellenfeld hergestellt werden. Dies beruht in erster Linie auf einem Auftreffen von unerwünschten Teilchen während einer Waferverarbeitung bei der Herstellung der Halbleiterspeicheranordnung und auch auf anderen Gründen, wie Kurzschlüssen usw. Um die damit verbundenen Probleme bewältigen zu können, werden daher allgemein redundante Speicherzellen mit redundanten Bitleitungen und Wortleitungen eingesetzt, die so ausgefallene Speicherzellen ersetzen können.

In der Praxis wird dabei so vorgegangen, daß nach Herstellung eines DRAMs noch auf Waferebene ein Test vorgenommen wird, mit dem alle ausgefallenen Speicherzellen des DRAMs lokalisiert werden sollen. Bei solchen ausgefallenen Speicherzellen kann es sich dabei um einzelne Speicherzellen, Gruppen von Speicherzellen oder sogar um vollständige Bitleitungen und Wortleitungen mit den entsprechenden Speicherzellen handeln. Nach Identifizierung der ausgefallenen Speicherzellen, was über deren entsprechende Adressierung geschieht, werden die Adressen der ausgefallenen Speicherzellen und gegebenenfalls Gruppen von Speicherzellen sowie Wortleitungen und Bitleitungen in einem externen Rechner abgelegt. Dieser externe Rechner führt sodann eine komplizierte Berechnung durch, in die einerseits die ausgefallenen Speicherzellen und andererseits die verfügbaren Spare-Speicherzellen eingehen. Unter "Speicherzellen" sind dabei selbstverständlich auch Gruppen von Speicherzellen sowie gegebenenfalls ganze Wortleitungen und Bitleitungen mit entsprechenden Speicherzellen zu verstehen. Bei dieser Berechnung wird ermittelt, wie auf optimale Weise die ausgefallenen Speicherzellen durch Spare-Speicherzellen zu ersetzen sind. Diese Berechnung ist äußerst aufwendig, was nicht zuletzt darauf zurückzuführen ist, daß eine möglichst hohe Ausbeute angestrebt wird. Das heißt, die ausgefallenen Speicherzellen sollen so durch die redundanten Speicherzellen ersetzt werden, daß von diesen möglichst wenige benötigt werden, d.h., die Anzahl der Spare-Speicherzellen soll gering gehalten werden.

Aufgrund dieser komplizierten Berechnung wurde bisher nicht daran gedacht, BIST-(Built-in-self-test-)Technologien gerade bei DRAMs einzusetzen, obwohl BIST an sich in der Mikroelektronik seit längerer Zeit verwendet wird. Mit BIST ist es nämlich ohne Verbrauch von viel Fläche auf dem Wafer nicht möglich, die notwendigen Berechnungen für einen optimalen Einsatz von redundanten Speicherzellen anstelle von ausgefallenen Speicherzellen vorzunehmen. Mit anderen Worten, diese Berechnungen setzen eine BIST-Recheneinheit voraus, deren Flächenbedarf das bei der Herstellung von DRAMs annehmbare Maß bei weitem überschreitet.

Aus dem Dokument KOWARK O.:" SELF-REPAIRING SEMICONDUCTOR MEMORY CHIP WITH IMPROVED AVAILABILITY/RELIABILITY", PROCEEDINGS OF THE CUSTOM INTEGRATED CIRCUITS CONFERENCE, US, NEW YORK, IEEE, Bd.CONF. 9, 1987, Seiten 598-601, ist eine redundante Halbleiter speicheranordnung bekannt, die eine BIST-Einheit aufweist, die im Laufe eines Selbst-Tests für jede Nortleitung die Anzahl von Fehlerhaften Speicherzellen zählt, wobei anschliessend eine Reparatur durchgeführt wird, bei der immer Bitleitungen ersetzt werden, es sei denn, die Anzahl fehlerhafter Speicherzellen übersteigt die Anzahl verfügbaren redundanten Bitleitungen, wobei die Nortleitung ersetzt wird.

Es liegt also eine zunächst nicht lösbar erscheinende Problematik vor: bei der Zuordnung redundanter Speicherzellen als Spare-Speicherzellen zu ausgefallenen Speicherzellen ist der Einsatz eines externen Rechners aufwendig und sollte möglichst vermieden werden. Ein Rückgriff auf die an sich verbreitete BIST-Technologie ist aber nicht möglich, da deren Verwendung zu viel Fläche von dem Wafer der Halbleiterspeicheranordnung im Anspruch nehmen würde. Aus diese Grund wurde bisher nicht daran gedacht, die BIST-Technologie bei der Herstellung von DRAMs einzusetzen, um ausgefallene Speicherzellen durch redundante Speicherzellen zu ersetzen.

Es ist nun Aufgabe der vorliegenden Erfindung, eine Halbleiterspeicheranordnung zu schaffen, die ohne aufwendigen externen Rechner dennoch in der Lage ist, ausgefallene Speicherzellen durch redundante Speicherzellen zu ersetzen.

Diese Aufgabe wird bei einer Halbleiterspeicheranordnung mit einem über Wortleitungen und Bitleitungen angesteuerten Speicherzellenfeld aus einer Vielzahl von Speicherzellen und mit redundanten Speicherzellen, die bei einem Ausfall von Speicherzellen des Speicherzellenfeldes diese als Spare-Speicherzellen ersetzen, wobei die Speicherzellen des Speicherzellenfeldes und die Spare-Speicherzellen auf einem Halbleiterchip vorgesehen sind, erfindungsgemäß durch die in Anspruch 1 definierten Merkale dadurch gelöst, daß im Halbleiterchip eine BIST-Recheneinheit vorgesehen ist, die den ausgefallenen Speicherzellen Spare-Speicherzellen zuordnet.

Für diese Zuordnung wird dabei ein besonderer Algorithmus herangezogen, bei dem beispielsweise für jede Adresse die Anzahl der ausgefallenen Speicherzellen als ein Hit-Wert gespeichert wird. Erreicht dieser Hit-Wert eine bestimmte Grenze, dann wird die gesamte, zu dieser Adresse gehörende Wortleitung (X-Richtung) bzw. Bitleitung (Y-Richtung) ersetzt. Einzelfehler können ansonsten wahlweise durch eine Wortleitung oder eine Bitleitung ersetzt werden.

Die BIST-Recheneinheit hat insbesondere ein Register, in welchem für die einzelnen Wortleitungen und Bitleitungen die Adressen der ausgefallenen Speicherzellen abspeicherbar sind. Dieses Register kann beispielsweise als Stapelregister ausgeführt sein und als Assoziativspeicher wirken.

Zusammenfassend wird also bei der erfindungsgemäßen Speicherzellenanordnung die Adreßinformation für ausgefallene Speicherzellen nicht in einem externen Speicher sondern auf dem Halbleiterchip selbst in Registern abgelegt. Mit Hilfe eines speziellen Algorithmus kann dabei die Anzahl der erforderlichen Register gering gehalten werden. Die BIST-Recheneinheit gibt dann die redundanten Speicherzellen an, die als Spare-Speicherzellen die ausgefallenen Speicherzellen reparieren.

Die erfindungsgemäße Halbleiterspeicheranordnung benötigt so keinen externen Rechner und kommt mit einer handhabbaren Anzahl von Registereinträgen aus, so daß nur wenig Chipfläche zu deren Realisierung erforderlich ist. Da die Adreßinformation der ausgefallenen Speicherzellen in Echtzeit abgespeichert wird, ist eine Verarbeitung mit hoher Geschwindigkeit möglich, die insbesondere auch keine Unterbrechung bei einem Testdurchlauf erforderlich macht. Weiterhin ist es möglich, in den Registern Information über ausgefallene Speicherzellen für mehrere einzelne Testdurchläufe anzusammeln.

Liegen auf der gleichen Bitleitung oder Wortleitung verschiedene ausgefallene Speicherzellen vor, so ist es durch Vorsehen einer Zählereinheit, die für jede X- und Y-Adresse die Anzahl der ausgefallenen Speicherzellen als ein Hit-Wert bis zu einer oberen Grenze speichert, möglich, die aufzuzeichnende Information einzuschränken, die dann auftreten würde, wenn in der gleichen Bitleitung oder Wortleitung eine Vielzahl von ausgefallenen Speicherzellen auftreten würde.

Schließlich begünstigt noch die Ausführung des Registers als ein assoziativer Speicher die Erzielung einer hohen Betriebsgeschwindigkeit.

Nachfolgend wird die Erfindung anhand der Zeichnungen näher erläutert. Es zeigen:
- Fig. 1: eine Prinzipdarstellung eines Speicherzellenfeldes bei der erfindungsgemäßen Halbleiterspeicheranordnung,
- Fig. 2: eine Darstellung für den Ablauf von drei Tests,
- Fig. 3 bis 5: Hit-Werte, die bei den anhand der Fig. 2 durchgeführten Tests erhalten sind, und
- Fig. 6: ein Blockschaltbild für den Aufbau der erfindungsgemäßen Halbleiterspeicheranordnung.

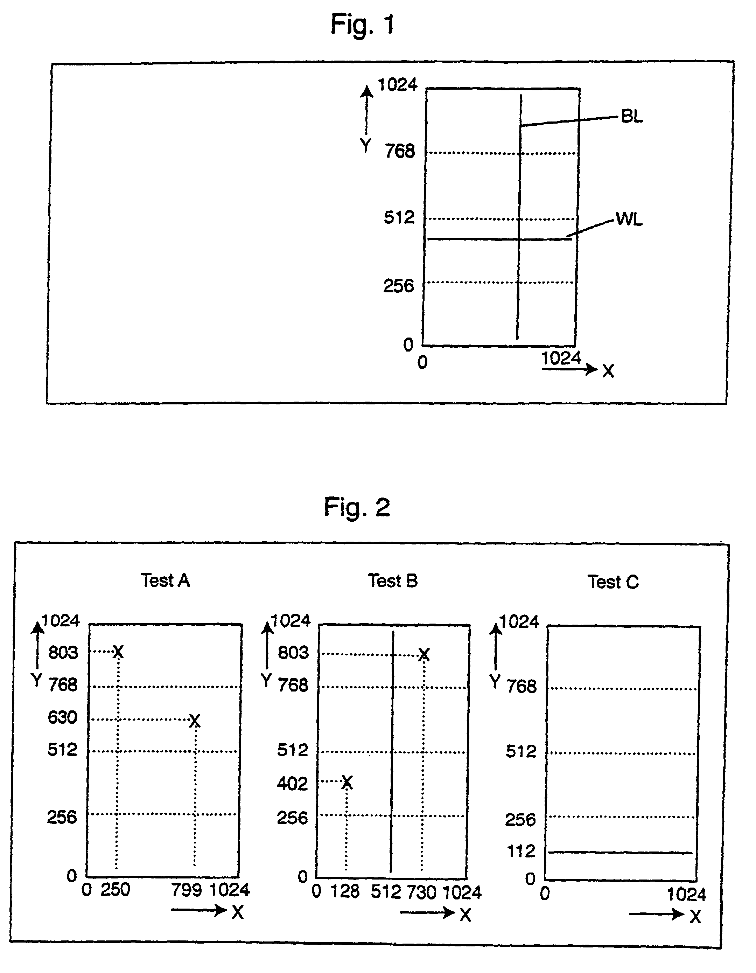

Fig. 1 zeigt ein Speicherzellenfeld eines DRAMs aus 1024 Wortleitungen in X-Richtung und 1024 Bitleitungen in Y-Richtung. An jedem Schnittpunkt einer Wortleitung mit einer Bitleitung ist eine nicht näher dargestellte Speicherzelle vorgesehen. Das so vorliegende Speicherzellenfeld hat also 1024 x 1024 Speicherzellen und bildet damit eine 1 Mb-Speicheranordnung. In Fig. 1 sind zur Vereinfachung der Darstellung eine Bitleitung BL und eine Wortleitung WL in Volllinien gezeigt.

Es sei nun angenommen, daß verschiedene redundante Bitleitungen und redundante Wortleitungen verfügbar sind, um gegebenenfalls ausgefallene Speicherzellen zu ersetzen. Solche ausgefallenen Speicherzellen können durch Tests ermittelt werden, indem die einzelnen Wortleitungen und Bitleitungen angesteuert werden, die zu den jeweiligen Speicherzellen führen.

Eine vollständige Testsequenz auf Waferebene zur Identifizierung ausgefallener Speicherzellen besteht dabei aus einer großen Anzahl einzelner Tests. Zur Vereinfachung sei nun angenommen, daß lediglich drei Tests A, B und C in einer vollständigen Testsequenz ausgeführt werden, wie dies in Fig. 2 veranschaulicht ist.

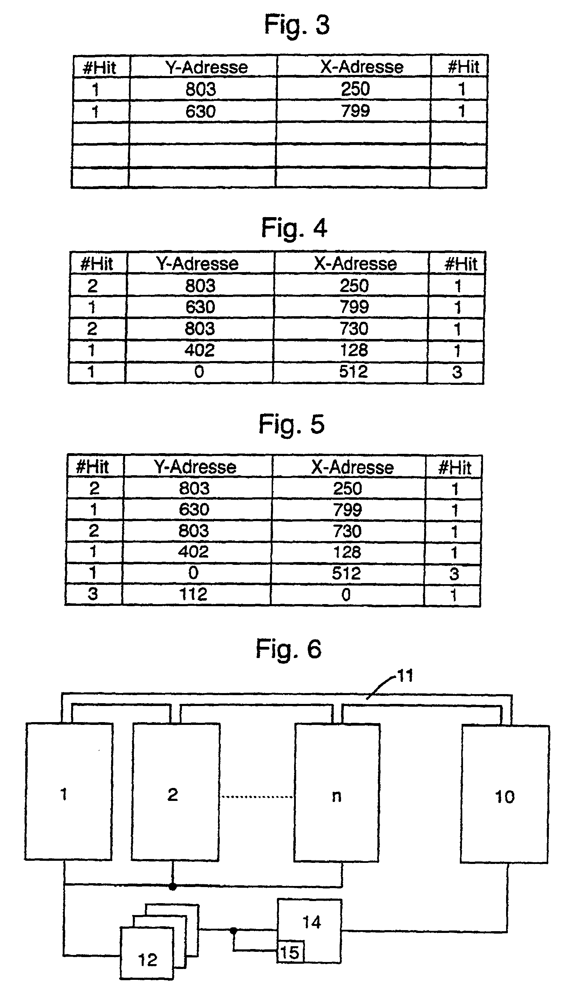

Fig. 2 gibt dabei ein Beispiel an, bei dem nach Durchführung jeweiliger Tests A, B und C verschiedene Speicherzellen bzw. Bits als fehlerhaft ermittelt sind. Dabei werden in einem ersten Test A zunächst zwei ausgefallene bzw. fehlerhafte Bits ermittelt, während in einem zweiten Test B zwei einzelne ausgefallene Bits und eine ausgefallene Bitleitung festgestellt werden, während im letzten Test C eine vollständige Wortleitung als fehlerhaft festgestellt wird. Die Adressen der jeweiligen fehlerhaften Bits bzw. Bitleitungen und Wortleitungen werden in einem Register während der Durchführung der Tests in Echtzeit abgelegt. Aus Fig. 3 ist der Inhalt eines solchen Registers nach Durchführung des ersten Tests ersichtlich.

Während des Tests A wird ein erstes ausgefallenes Bit bei einer Stelle 803/250 festgestellt. Da kein ähnlicher Eintrag bei 803 bzw. 250 vorliegt, wird dieser Ausfall unter der Y-Adresse 803 mit dem Hit-Wert 1 und unter der X-Adresse 250 mit dem Hit-Wert 1 abgespeichert. Ähnliches gilt auch für den Ausfall an der Stelle 630/799: unter der Y-Adresse 630 wird der Hit-Wert 1 abgelegt, während unter der X-Adresse 799 ebenfalls der Hit-Wert 1 aufgezeichnet wird.

Es schließt sich sodann der Test B an. Eine einzelne ausgefallene Speicherzelle soll hier bei 803/730 festgestellt werden. Für den Fall, daß das gleiche Adressenpaar bereits in dem Register abgelegt ist, sollten die jeweiligen Hit-Werte jeweils um 1 erhöht werden. Im vorliegenden Fall liegt nun lediglich die Zeilenadresse 803 bereits vor. Daher wird 803/730 in das Register eingegeben, und der Hit-Wert für die Y-Adresse 803 wird auf 2 erhöht, da bei dieser Y-Adresse 803 nun zwei "Hits" vorliegen.

Eine weitere fehlerhafte Speicherzelle wird im Test B ähnlich zu den Stellen 803/250 und 630/799 von Test A bei der Stelle 402/128 ermittelt.

Ein Spezialfall tritt jedoch im Test B für eine fehlerhafte Bitleitung bei X/512 auf. Bei einer üblichen Auswertung würde eine solche fehlerhafte Bitleitung zu einem übermäßig großen Register führen, das im vorliegenden Fall 1024 Stapel umfassen würde. Dies kann jedoch bei der erfindungsgemäßen Halbleiterspeicheranordnung durch die Anwendung eines speziellen Algorithmus vermieden werden: wann immer der Hit-Wert einen gewissen Schwellenwert überschreitet, der beispielsweise 3 betragen kann, wird angenommen, daß eine vollständige Spare-Spalte oder Spare-Zeile heranzuziehen ist. Mit anderen Worten, wenn also beispielsweise 3 oder mehr Hits für eine Y-Adresse und 3 oder mehr Hits für eine X-Adresse auftreten, so wird "automatische die gesamte Spalte bzw. Zeile durch eine Bitleitung bzw. Wortleitung ersetzt.

Dieser Vorgang soll im folgenden noch kurz erläutert werden: es sei beispielsweise angenommen, daß das erste ausgefallene Bit auf der fehlerhaften Bitleitung bei 0/512 festgestellt wird. Dieser Wert wird dann in das Register eingegeben. Der nächste Ausfall kann dann beispielsweise bei 1/512 ermittelt werden. Auch dieser Wert wird in das Register eingegeben, und der Hit-Wert auf der Y-Adresse 512 wird auf 2 gesteigert. Nach Erfassung des dritten Ausfalles auf dieser Bitleitung bei beispielsweise 2/512 ist der oben genannte Schwellenwert von 3 erreicht. Damit ist klar, daß eine Spare-Spalte zur Reparatur der ausgefallenen Bitleitung heranzuziehen ist. Es ist dann ausreichend, den einzigen Eintrag für die Spalte 512 in dem Register bei dem Hit-Wert 3 zu halten, während die übrigen Einträge entfernt werden können. Fig. 4 zeigt so den endgültigen Inhalt des Registers nach Abschluß des Tests B.

Schließlich sei angenommen, daß in dem letzten Test C eine ausgefallene Wortleitung bei X/112 festgestellt wird. Genau der gleiche Algorithmus, wie dieser oben für die Bitleitung Y/512 erläutert wurde, führt dann zu einem Registerinhalt, wie dieser in Fig. 5 gezeigt ist.

Die nach den Tests A, B und C erhaltenen Informationen über ausgefallene Speicherzelle bzw. Bitleitungen und Wortleitungen können sodann ausgewertet werden, um die bestmögliche Zuordnung von Spare-Speicherzellen bzw. Spare-Spalten und Spare-Zeilen zu ermitteln, um alle ausgefallenen Speicherzellen bzw. Bitleitungen und Wortleitungen durch redundante Speicherzellen bzw. Bitleitungen und Wortleitungen zu ersetzen. Diese Berechnung kann ohne weiteres in der BIST-Recheneinheit auf dem Halbleiterchip oder aber auch extern vorgenommen werden.

In einem Beispiel für den Hit-Wert 3 besteht kein Freiheitsgrad in der Ersetzung durch eine Spare-Bitleitung oder eine Spare-Wortleitung. So bedeutet Hit = 3 für die X-Adresse, daß eine Spare-Bitleitung verwendet werden muß.

Das Register kann in vorteilhafter Weise als Assoziativspeicher ausgeführt werden. Jeder Hit-Wert wird durch wenigstens zwei Bits dargestellt, und etwa dreizehn Bits je Adresse erfordern ungefähr zwanzig Bits für einen einzigen Eintrag in dem Register. Ein derartiges Assoziativverhalten kann mit in der Größenordnung von 20 NAND-Gattern und 20 XOR-Gattern mit zwei Eingängen pro Registereintrag realisiert werden.

Das Register benötigt eine Kapazität, die ausreichend ist, die gesamte Information ausgefallener Speicherzellen, also höchstens die Gesamtzahl der redundanten Bitleitungen und der redundanten Wortleitungen, zu speichern.

Gegebenenfalls ist es aber auch möglich, nur Ergebnisse einzelner Tests in den Registern abzulegen und Zwischenergebnisse jeweils in dem noch fehlerbehafteten DRAM zu speichern: nach Ausführung des Tests A werden im obigen Beispiel die Zwischenergebnisse in dem fehlerbehafteten DRAM selbst abgelegt. Sobald der Test B abgeschlossen ist, werden die Ergebnisse des Tests A mit den Ergebnissen des Tests B fortgeschrieben und anstelle der Ergebnisse des Tests A im DRAM abgelegt. Damit ist das Register wieder frei für die Ergebnisse des Tests C. In entsprechender Weise kann dieses Vorgehen fortgesetzt werden. Selbstverständlich können auch geeignete Methoden zum redundanten Abspeichern der Information im fehlerbehaftetem DRAM selbst entwickelt werden.

Fig. 6 zeigt noch ein Blockschaltbild zur Realisierung der erfindungsgemäßen Halbleiterspeicheranordnung: diese besteht aus einer Vielzahl von Speicherzellenfeldern 1, 2, ..., n. Jedes dieser Speicherzellenfelder 1, 2, ..., n ist in der Weise aufgebaut, wie dies beispielsweise in Fig. 1 gezeigt ist. Dabei ist es möglich, in jedem der Speicherzellenfelder 1, 2, ..., n redundante Bitleitungen und Wortleitungen mit entsprechenden Speicherzellen vorzusehen. Ebenso ist es aber auch möglich, diese redundanten Bitleitungen und Wortleitungen mit den entsprechenden Speicherzellen in einem gesonderten Speicherzellenfeld 10 unterzubringen.

In einem Test werden die einzelnen Speicherzellenfelder durch Ansteuerung von deren Wortleitungen und Bitleitungen überprüft, um fehlerhafte Speicherzellen bzw. Wortleitungen und Bitleitungen zu ermitteln, wie dies oben erläutert wurde. Die Ergebnisse dieses Tests werden in einem Register 12 abgelegt. Es ist aber auch möglich, die Ergebnisse im fehlerbehaftetem DRAM selbst zu speichern. So können beispielsweise beim Testen des Speicherfeldes 1 die Ergebnisse im noch ungetesteten Speicherfeld 10 abgelegt werden. Dies setzt allerdings eine hochredundante Abspeicherung der Information voraus. Eine BIST-Recheneinheit 14 mit einer Zählereinheit 15 zum Zählen der Hit-Werte bis zu einer oberen Grenze wertet dann die schließlich in den Registern 12 gespeicherten Ergebnisse der Tests nach deren Abschluß aus und bestimmt diejenigen redundanten Speicherzellen, Bitleitungen und Wortleitungen, die als Spare-Speicherzellen, Spare-Bitleitungen und Spare-Wortleitungen aus dem Speicherzellenfeld 10 die fehlerhaften Speicherzellen, Bitleitungen und Wortleitungen in den Speicherzellenfeldern 1, 2, ..., n ersetzen sollen. Dieses Ersetzen der Speicherzellen, Bitleitungen und Wortleitungen erfolgt beispielsweise über entsprechende Busleitungen 11, die die einzelnen Speicherzellenfelder miteinander verbinden.

## Patentansprüche

1. Halbleiterspeicheranordnung mit einem über Wortleitungen (WL) und Bitleitungen (BL) angesteuerten Speicherzellenfeld (1, 2, ..., n) aus einer Vielzahl von Speicherzellen und mit redundanten Speicherzellen, die bei einem Ausfall von Speicherzellen des Speicherzellenfeldes diese als Spare-Speicherzellen ersetzen, wobei die Speicherzellen des Speicherzellenfeldes und die Spare-Speicherzellen auf einem Halbleiterchip vorgesehen sind, in welchem zusätzlich eine BIST-Recheneinheit (14) vorgesehen ist, die den ausgefallenen Speicherzellen die Spare-Speicherzellen zuordnet und mit Registern (12) vorgesehen ist, in denen für die einzelnen Wortleitungen und Bitleitungen die Adressen der ausgefallenen Speicherzellen abspeicherbar sind,
**gekennzeichnet durch**
eine in der BIST-Recheneinheit (14) vorgesehene Zählereinheit (15), die für jede der in den Registern (12) ubgespeicherten Adressen die Anzahl der ausgefallenen Speicherzellen als einen Hit-Wert bis zu einer oberen Grenze hochzählt, bei dessen Überschreitung die entsprechende Wortleitung bzw. Bitleitung ersetzt wird und wobei Einzelfehler wahlweise **durch** eine Wortleitung oder eine Bitleitung ersetzt werden.

2. Halbleiterspeicheranordnung nach Anspruch 1,
**dadurch gekennzeichnet,**
**daß** die Register (12) als Stapelregister ausgeführt sind.

3. Halbleiterspeicheranordnung nach Anspruch 2,
**dadurch gekennzeichnet,**
**daß** die Stapelregister als Assoziativspeicher aufgebaut ist.

4. Halbleiterspeicheranordnung nach einem der Ansprüche 1 bis 3,
**dadurch gekennzeichnet,**
**daß** den Registern (12) ein fehlerbehafteter Teil eines DRAMs zugeordnet ist, in welchem Teilergebnisse von Tests abspeicherbar sind.

## Claims

1. Semiconductor memory arrangement having, addressed via word lines (WL) and bit lines (BL), a memory cell array (1, 2, ..., n) comprising a multiplicity of memory cells and having redundant memory cells which, in the event of failure of memory cells of the memory cell array, replace said memory cells as spare memory cells, the memory cells of the memory cell array and the spare memory cells being provided on a semiconductor chip in which a BIST computing unit (14) is additionally provided, which computing unit assigns the spare memory cells to the failed memory cells and is provided with registers (12), in which the addresses of the failed memory cells can be stored for the individual word lines and bit lines,
**characterized by**
a counter unit (15), which is provided in the BIST computing unit (14) and, for each of the addresses stored in the registers (12), increments the number of failed memory cells as a hit value up to an upper limit, the corresponding word line or bit line being replaced in the event of said upper limit being exceeded, and where individual defects are optionally replaced by a word line or a bit line.

2. Semiconductor memory according to Claim 1,
**characterized**
**in that** the registers (12) are designed as stack registers.

3. Semiconductor memory arrangement according to Claim 2,
**characterized**
**in that** the stack registers is [sic] constructed as associative memories.

4. Semiconductor memory arrangement according to one of Claims 1 to 3,
**characterized**
**in that** the registers (12) are assigned a defective part of a DRAM in which partial results of tests can be stored;

## Revendications

1. Circuit de mémoire à semi-conducteurs comportant un champ de cellules mémoire (1, 2,..., n) sélectionné par l'intermédiaire de lignes de mots (LM) et de lignes de bits (LB), se composant d'un grand nombre de cellules mémoire et de cellules mémoire redondantes, assurant la fonction de cellules mémoire de remplacement, dans le cas d'une défaillance des cellules mémoire du champ, celles-ci, de même que les cellules mémoire de remplacement, étant prévues sur une puce à semi-conducteurs, dans laquelle est prévue en supplément une unité de calcul BIST (14) associant les cellules mémoire de remplacement aux cellules mémoire défaillantes, et des registres (12) dans lesquels les adresses des cellules mémoire défaillantes pour les différentes lignes de mots et lignes de bits peuvent être mises en mémoire,
**caractérisé par**
une unité de comptage (15) prévue dans l'unité de calcul BIST (14) extrapolant pour chacune des adresses mémorisées dans les registres (12) le nombre de cellules mémoire défaillantes sous forme d'une valeur hit à concurrence d'une limite supérieure, au-delà de laquelle la ligne de mots ou la ligne de bits est remplacée, les erreurs individuelles étant remplacées au choix par une ligne de mots ou par une ligne de bits,

2. Circuit de mémoire à semi-conducteur selon la revendication 1,
**caractérisé en ce que**
les registres (12) consistent en des registres d'empilage,

3. Circuit de mémoire à semi-conducteur selon la revendication 2,
**caractérisé en ce que**
les registres d'empilage sont constitués de mémoires associatives,

4. Circuit de mémoire à semi-conducteur selon l'une quelconque des revendications 1 à 3,
**caractérisé en ce que**
un élément défaillant d'un DRAM est associé aux registres (12), DRAM dans lequel des résultats partiels de tests peuvent être mis en mémoire.
